# FASCICULE DE BREVET EUROPEEN

(11) **EP 0 453 351 B1**
(45) Date de publication et mention de la délivrance du brevet: **11.08.1993**
(21) Numéro de dépôt: 91400938.6
(22) Date de dépôt: 08.04.1991
(51) Int. Cl.: G11C 17/16, G11C 17/18

(54) **Circuit de détection de fusible**
Sicherungsdetektorschaltung
Fuse-detection circuit

(30) Priorité: 10.04.1990 FR 9004584
(43) Date de publication de la demande: 23.10.1991
(73) Titulaire: SGS-THOMSON MICROELECTRONICS S.A., 94250 Gentilly (FR)
(72) Inventeur: Fruhauf, Serge, F-75116 Paris (FR); Tailliet, François, F-75116 Paris (FR)
(74) Mandataire: Schmit, Christian Norbert Marie

(56) Documents cités:
- EP-A- 0 151 849
- EP-A- 0 252 325

## Description

La présente invention a pour objet un circuit de détection de fusible à claquage vertical d'oxyde.

Les fusibles sont utilisés dans les circuits intégrés, par exemple pour la définition de fonctions ou de chemins d'accès, ou comme fonction de verrouillage d'accès dans des circuits sécurisés. Ils ont deux états possibles : l'état initial, intact, l'état final irréversible, claqué.

Les fusibles actuellement utilisés dans les circuits intégrés peuvent être réalisés :
- en métal. Ils présentent alors l'inconvénient de pouvoir être court-circuités.
- en polysilicium. Ils présentent alors l'inconvénient de pouvoir se reconstituer ultérieurement. Pour améliorer la fiabilité de ce type de fusible, on peut utiliser deux fusibles au lieu d'un seul, chacun pouvant être claqué (demande EP-0 252 325).
- à base de 2 cellules EEPROM. Les cellules vierges sont dans un même état inconnu; l'une peut-être seulement effacée, l'autre seulement programmée : le claquage est obtenu par exemple en commandant la programmation de la double cellule ; comme une seule cellule peut-être programmée, la sortie OR combinée des deux cellules change d'état. Mais un tel circuit prend beaucoup de place.
- à partir d'une cellule EEPROM, dont le claquage consiste à volatiliser son oxyde tunnel par l'envoi par exemple d'un ou plusieurs fronts très raides de programmation.

Mais les circuits d'écriture et de lecture sont alors complexes et un tel fusible est encombrant.

On connaît l'association d'une zone d'oxyde très mince à un transistor, le but de la zone d'oxyde étant de faire changer d'état le transistor : une telle utilisation est décrite dans la demande de brevet US 4,701,780. Cette utilisation est sensiblement équivalente à celle d'une cellule EEPROM à claquage d'oxyde tunnel.

Dans l'invention, on utilise seulement la capacité, c'est à dire une zone d'oxyde très mince, pour réaliser un fusible. L'épaisseur d'oxyde du fusible est par exemple de 80 A°. Le champ électrique nécessaire au claquage est alors de l'ordre de 20mv/A°. En pratique, une tension de claquage de 17 volts appliquée aux bornes de la capacité suffit. Cette tension de claquage est appliquée par exemple classiquement par un transistor commandé par le signal de claquage. La tension de claquage provient soit d'une pompe de charge interne, qui, à partir de la tension d'alimentation 5 volts du circuit intégré, produit une telle tension de claquage, soit d'un plot externe, avec alors protection ESD pour éviter un mauvais fonctionnement.

Un tel fusible est l'équivalent d'une capacité à l'état initial. Il est l'équivalent d'une résistance à l'état claqué. On ne peut donc utiliser des circuits de détection de fusibles connus.

En effet, dans le cas de fusibles en métal ou polysilicium, leur état initial est équivalent à une résistance et leur état claqué est équivalent à un circuit ouvert : les états à détecter sont différents de ceux du fusible à claquage d'oxyde; le principe de détection ne peut donc être le même.

Dans le cas de cellules EEPROM, le circuit de détection est un détecteur du courant circulant dans la cellule. Il ne peut s'appliquer à un fusible à claquage vertical d'oxyde non associé à une telle cellule EEPROM.

Dans l'invention, on utilise dans le circuit de détection d'un fusible, un second fusible qui ne peut être claqué : ce second fusible est donc toujours dans l'état initial. Un circuit de référence de tension associé à chacun des fusibles impose alors une tension de référence dont le niveau est fonction de l'état du fusible.

Les deux tensions de référence sont ainsi appliquées aux deux entrées d'un comparateur différentiel. Si les 2 fusibles sont dans le même état initial, les deux tensions de référence sont égales. La sortie S du comparateur est par exemple de 5 volts. Si le premier fusible est claqué, les deux tensions de référence ne sont plus égales et la sortie du comparateur bascule à 0 volt.

Ainsi l'invention a pour objet un circuit de détection d'un fusible à 2 états possibles, du type à claquage vertical d'oxyde, caractérisé en ce qu'il comporte un second fusible du même type, mais ne pouvant pas être claqué, le premier fusible comportant en parallèle, entre la masse et un premier point d'entrée d'un comparateur différentiel un premier circuit de référence de tension et le second fusible comportant en parallèle, entre la masse et un second point d'entrée d'un comparateur différentiel un second circuit de référence de tension.

L'invention sera mieux comprise à la lecture de la description qui suit et à l'examen des figures qui l'accompagnent. Celles-ci ne sont données qu'à titre indicatif et nullement limitatif de l'invention. Dans ces figures,
- la figure 1 est un schéma de principe d'un circuit de détection selon l'invention.
- la figure 2 est un exemple de réalisation d'un circuit selon l'invention.

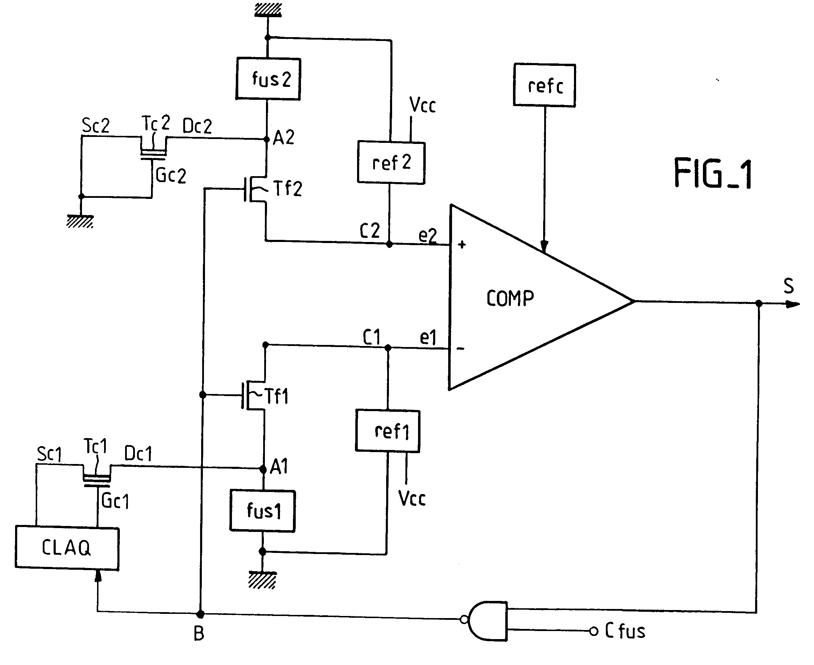

La figure 1 est un schéma de principe d'un circuit selon l'invention.

Un comparateur différentiel COMP a deux entrées e1, e2, une sortie S, et une référence de tension propre refc.

Un fusible fus1 et un fusible fus2 ont chacun leurs deux bornes reliées l'une à la masse, l'autre à un noeud respectivement A1, A2.

Un transistor MOS Tf1, respectivement Tf2, est placé en série entre le noeud A1, respectivement A2, et un noeud C1, correspondant à l'entrée e1 du comparateur, respectivement C2, correspondant à l'entrée e2.
Entre la masse et respectivement le noeud C1, C2, on a un circuit de référence de tension refl, ref2.

En série entre un circuit de claquage CLAQ et le noeud A1, est placé un transistor MOS Tc1 de claquage du fusible fus1. Dans l'exemple il est de type N, natif, avec une tension de seuil très légèrement supérieure à 0 volts, de l'ordre de 200mv. Sa grille Gc1 et sa source Sc1 sont commandées par le circuit de claquage. Son drain Dc1 est relié au noeud A1. C'est le transistor Tc1 qui, sur une commande de claquage, amène la tension de claquage Vpp sur la borne A1 du fusible fus1 : le transistor Tc1 est alors équivalent à un court-circuit.

En série entre la masse et le noeud A2, est placé un transistor MOS Tc2. Le transistor Tc2 est technologiquement identique au transistor Tc1. Il est dans l'exemple natif, avec une tension de seuil très légèrement supérieure à 0 volts, de l'ordre de 200mv. Sa grille Gc2 et sa source Sc2 sont reliées à la masse : il est toujours bloqué. Son drain Dc2 est relié au noeud A2.

La sortie S du comparateur est rebouclée sur une entrée d'une porte logique NAND. L'autre entrée de la porte NAND est une commande de claquage Cfus du fusible fus1. La sortie de la porte NAND est reliée au circuit de claquage, qu'elle commande. La sortie de la porte NAND est aussi reliée au noeud B aux grilles des transistors Tf1 et Tf2.

Les transistors Tf1 et Tf2 permettent d'empêcher la lecture de l'état du fusible fus1 pendant le claquage de ce fusible, pour que le comparateur ne donne pas une information de sortie S erronée pendant le changement d'état du fusible. En effet, pendant le changement d'état, il faut que les noeuds C1 et C2 restent à un même potentiel identique, pour que la sortie S du comparateur ne bascule pas et interdise alors le claquage du fusible fus1 par contre-réaction de la sortie de la porte NAND.

Le rôle des transistors Tc2 et Tf2 est, comme on le verra dans la suite, d'avoir les 2 entrées e1 et e2 du comparateur à un potentiel le plus identique possible, quand le fusible fus1 n'est pas claqué : pour que ces tensions en e1 et en e2 soient identiques, il faut que les circuits qui définissent ces tensions soient identiques.

Quand le fusible fus1 n'est pas claqué, fus2 étant dans le même état, les deux fusibles sont chacun équivalent à une capacité. Les deux fusibles étant dans l'invention technologiquement identiques, leurs capacités équivalentes sont de valeurs identiques. Les circuits de référence refl, ref2 sont aussi technologiquement identiques dans l'invention : à l'entrée du comparateur, les tensions e1, e2 deviennent chacune égale à la tension de référence Vref1 = Vref2 fournie par les circuits de référence de tension refl, ref2 associés aux fusibles fus1, fus2.

Quand le fusible fus1 est claqué, il est équivalent à une résistance : il appelle un certain courant qui est fourni par le circuit de référence de tension associé, refl : la tension de sortie du circuit de référence de tension refl, au noeud C1, est alors tirée vers la masse. Le noeud C1 qui correspond à l'entrée e1 du comparateur prend donc une valeur proche de 0 volt, en fonction de la valeur de la résistance équivalente du fusible fus1 claqué et du courant que peut fournir le circuit de référence de tension refl. L'autre entrée e2 du comparateur est, quant à elle, toujours égale à Vref2 : la sortie S du comparateur va donc basculer.

Ainsi, l'utilisation d'un circuit de référence de tension en parallèle sur chacun des fusibles, et d'un comparateur différentiel permet une détection simple de l'état du fusible fus1.

Cette détection est d'autant plus fiable que l'ensemble des circuits associés à chaque entrée du comparateur est le plus identique possible sur chaque entrée.

On a vu que la porte NAND permettait d'isoler le circuit de détection pendant le claquage du fusible fus1. Elle permet aussi d'empêcher des fraudeurs, quand le fusible est déjà claqué, de mettre une tension de claquage sur le fusible fus1 d'une valeur telle que l'on ait à nouveau une tension e1 égale à Vref1. Le fusible fus1 serait vu, des circuits en aval de lui et pour lesquels la détection est justement faite, comme étant non claqué. Une telle sécurité est nécessaire notamment pour les fonctions de verrouillage d'accès, et surtout quand la tension de claquage Vpp est fournie sur un plot externe.

Enfin, le comparateur est commandé par un circuit de référence de tension interne refc, qui délivre une tension de référence Vcomp et qui permet de s'affranchir
des fluctuations de la tension d'alimentation Vcc, qui pertuberaient le fonctionnement du comparateur.

Le circuit de détection est alors doublement isolé de l'alimentation : d'abord par le circuit de référence interne refc, et ensuite par le comparateur différentiel, qui déclenche uniquement sur une différence de tension e2-e1, chaque branche de circuit associée à e2 et e1 étant parfaitement identique selon l'invention.

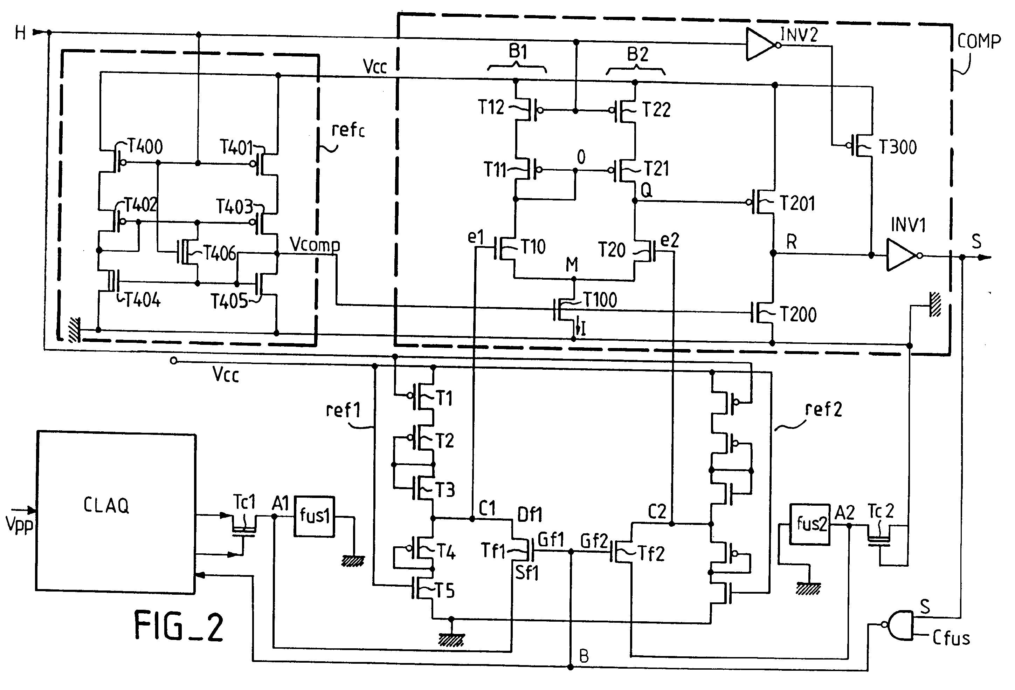

La figure 2 est un exemple de réalisation d'un circuit de détection selon l'invention.

Le fusible fus1 est connecté entre la masse et un noeud A1. Ce noeud A1 est connecté à la source Sf1 d'un transistor de type N, Tf1. Ce transistor monté en série avec le fusible, permet d'isoler le comparateur du fusible, le temps de l'opération de claquage, en le mettant en circuit ouvert (Tf1 non-conducteur) par la commande imposée sur sa grille Gf1 reliée au noeud B. Le drain Df1 est relié au noeud C1 de sortie d'un circuit de référence de tension ref1.

Le circuit de référence de tension refl comporte dans l'exemple :
- une première branche entre Vcc et le noeud C1 comportant trois transistors T1, T2 et T3 montés en série.

Le transistor T1 agit comme un interrupteur qui amène ou non la tension Vcc sur la source du transistor T2 de type P. La grille du transistor T1 de type P est commandé par un signal de commande de tension H. La source du transistor T1 est connectée à Vcc. Dans ces conditions, le transistor T1 est équivalent à un interrupteur fermé, quand le signal H est mis au 0 volt. Quand le signal H est à 5 volts, le transistor T1 est équivalent à un circuit ouvert. Le drain du transistor T1 est connecté à la source du transistor T2. Le drain du transistor T2 est connecté au drain du transistor T3 de type N, la source du transistor T3 est connectée au noeud C1. Les grilles des transistors T2 et T3, la source du transistor T3 et le drain du transistor T2 sont reliés ensemble.
- Une deuxième branche entre le noeud C1 et la masse comporte un transistor T4 de type P en série avec un transistor T5 de type N. Le drain et la grille du transistor T4 sont reliés ensemble, et au drain du transistor T5. La source du transistor T5 est reliée à la masse. La grille du transistor T5 est reliée à Vcc. Un tel circuit de référence de tension est stable en température car il comporte, hormis le transistor T1 qui fait office d'interrupteur, autant de transistors P que de transistors N. Les caractéristiques technologiques de chaque branche sont alors identiques, et la référence de tension Vref1, obtenue en C1 par ce montage en diviseur de tension, est stable.

Le noeud C1 est par ailleurs connecté à l'entrée e1 du comparateur COMP.

Le fusible fus2 est monté en série de manière identique au fusible fus1 avec un transistor Tf2 dont la grille est aussi connectée au noeud B, comme le transistor Tf1. Le drain du transistor Tf2 est connecté au noeud C2. Le noeud C2 est de plus relié, d'une part à un circuit de référence de tension ref2 identique au circuit de référence de tension refl et, d'autre part, à l'entrée e2 du comparateur COMP.

Le transistor Tf2 est technologiquement identique au transistor Tf1. Les circuits de référence de tension refl et ref2 sont technologiquement identiques. Ainsi le circuit compris entre un fusible et une entrée du comparateur a les mêmes caractéristiques sur chaque entrée e1, e2 : le comparateur est équilibré.

Le comparateur est, dans un exemple de réalisation connu, constitué de deux branches B1 et B2, la branche B1 étant commandée par l'entrée e1 et la branche B2 par l'entrée e2.

La branche B1 comprend en série entre Vcc et un noeud M, trois transistors :
- un transistor T12 de type P
- un transistor T11 de type P
- un transistor T10 de type N

Le transistor T12 de type P sert d'interrupteur, comme le transistor T1 de la référence de tension ref1 : sa source est reliée à Vcc et sa grille au signal H de commande de tension. Son drain est relié à la source du transistor T11. La grille et le drain du transistor T11 sont reliés ensemble au drain du transistor T10. La source du transistor T10 est reliée au noeud M. La grille du transistor T10 est l'entrée e1 du comparateur.

La branche B2 comprend en série entre Vcc et le noeud M, trois transistors :
- un transistor T22 de type P,
- un transistor T21 de type P,
- un transistor T20 de type N,

Le transistor T22 de type P sert d'interrupteur comme le transistor T12 : sa source est reliée à Vcc, et sa grille au signal H de commande de tension. Son drain est relié à la source du transistor T21. La grille du transistor T21 est reliée à celle du transistor T11 au noeud O. Le drain du transistor T21 est relié au noeud Q, au drain du transistor T20. La source du transistor T20 est reliée au noeud M. La grille du transistor T20 est l'entrée e2 du comparateur.

Un transistor de type N, T100 est monté en série entre le noeud M et la masse Vss du circuit. Sa grille est alimentée par la référence de tension Vcomp fournie par le circuit de référence de tension refc associé au comparateur. Ce circuit de référence de tension refc est de préférence indépendant de la tension d'alimentation Vcc. La tension Vcomp qu'il délivre est donc invariante avec Vcc. Comme on le verra dans la suite, Vcomp est de l'ordre de la tension de seuil du transistor T100 : un courant I circule donc dans le transistor T100. Ce courant est fixe puisque la tension de grille du transistor T100 est fixe (toujours les mêmes conditions de polarisation) : c'est le courant imposé par un transistor T405 du circuit de référence de tension refc et par rapport auquel il est monté en miroir de courant, comme on le verra plus loin. Le courant I est proportionnel au courant circulant dans le transistor T405.

Quand les 2 fusibles sont à l'état initial intact, les deux entrées e1 et e2 sont au même niveau de tension Vref1=Vref2, délivré par les circuits de référence de tension refl et ref2. Le courant qui circule dans les deux branches B1 et B2 du comparateur est alors le même, égal à I/2. En effet le transistor T21 est monté en miroir de courant par rapport au transistor T11 (monté en diode polarisée en direct) : le courant circulant dans la branche B2 est proportionnel à celui circulant dans la branche B1. Le courant dans la branche B1 est fixé par le transistor T10 qui se comporte, comme une résistance. Comme les transistors T10 et T20 sont identiques et que leurs tensions de grille e1 et e2 sont égales, le même courant circule dans les branches B1 et B2. La tension au noeud O est alors proche de Vcc-VT11, VT11 étant la tension de seuil du transistor T11. La tension au noeud Q prend une valeur dépendant des résistivités respectives des transistors T20 et T21 et peut être égale au maximum à Vcc.

Quand le fusible fus1 est claqué, il est équivalent à une résistance et appelle un certain courant qui fait tendre le noeud C1, relié à l'entrée e1, vers une tension proche de 0 volts. Le transistor T10, dont la grille est alors à une tension proche de 0 volts, est bloqué. Le potentiel au noeud O monte jusqu'à ce que les transistors à canal P T11 et T21 deviennent très résistifs. Le transistor T20 à canal N, dont la grille est toujours à une tension e2=Vref2, est toujours conducteur: tout le courant I appelé par T100 passe donc dans la branche B2. Le transistor T20 est moins résistif que le transistor T21 : il accepte tout le courant I et c'est lui qui va imposer le potentiel au noeud Q : il tend donc à faire descendre ce potentiel au maximum, c'est à dire à une valeur sensiblement égale à son seuil de conduction : e2-VT20, VT20 étant la tension de seuil du transistor T20.

Un inverseur placé au noeud Q, constitué classiquement d'un transistor P, T201 entre Vcc et un noeud R et d'un transistor N, T200 entre le noeud R et la masse, permet de manière connue de distinguer entre les deux états mis en évidence dans les deux paragraphes précédent :

Dans l'exemple, la grille du transistor T200 est alimentée par la référence de tension Vcomp. La source du transistor T201 est alimentée par Vcc. Le transistor T200 demande toujours le même courant I, puisqu'il est monté en miroir de courant par rapport au transistor T405 (T200 se comporte comme un générateur de courant, comme le transistor T100). T201 se comporte lui comme une résistance commandée:

Quand le fusible fus1 n'est pas claqué, le potentiel au noeud Q est fort, par exemple de l'ordre de Vcc, la source du transistor T21 étant à Vcc. Alors le potentiel au noeud R tombe à 0 volts.

Quand le fusible fus1 est claqué, le potentiel au noeud Q est plus faible, par exemple de l'ordre de e2-VT20. Le potentiel au noeud R remonte. Au maximum, il remonte à Vcc, suivant les résistivités respectives des transistors T200 et T201.

Un inverseur INV1, placé en sortie du noeud R, donne alors, pour le fusible non claqué, une sortie 5 volts et pour un fusible claqué, une sortie 0 volts. Il permet de redresser le signal : la sortie de l'inverseur INV1 est la sortie S du comparateur.

Avantageusement, un inverseur INV2 suivi en série d'un transistor P T300, sont montés en parallèle entre un point d'entrée du signal H de commande de tension et l'entrée de l'inverseur INV1. Ainsi, quand le circuit n'est pas actif, le signal H est à Vcc et T300 est conducteur, tous les autres transistors associés au signal H étant eux bloqués (T1, T400, T12, ...). Alors le transistor T300 impose à l'entrée de l'inverseur INV1 une tension Vcc : la sortie S du comparateur est ainsi forcée à 0. Le fusible est vu comme étant claqué : c'est une fonction sécurité quand le circuit ne fonctionne pas.

Le circuit de référence de tension refc est par exemple réalisé par un montage à miroir de courant : un tel circuit a l'avantage de fournir une référence de tension indépendante de la tension d'alimentation Vcc. Il comporte par exemple 2 transistors de type P, T400 et T401 montés chacun en interrupteur, pareillement aux transistors T12 et T22 du comparateur.

En série avec le transistor T400, un transistor de type P, T402 monté en diode (grille et drain reliés ensemble), est lui-même placé en série avec un transistor N T404, natif. En série avec le transistor T401, un transistor de type P T403, est placé en série avec un transistor N T405 monté en diode.

Les sources des transistors N T404 et T405 sont reliées à la masse. Les grilles des transistors T 404 et T 405 sont reliées ensemble. Les grilles des transistors T 402 et T 403 sont reliées ensemble. Une telle construction permet de se rendre indépendant de la tension d'alimentation, car le transistor T402 monté en diode impose son courant dans le transistor T403 (principe du miroir de courant) et de même le transistor T405 monté en diode impose son courant au transistor T404 : à l'équilibre entre les deux branches constituées respectivement des transistors T402 et T404, T403 et T405, le même courant circule dans les deux branches. Les transistors montés en diode ont leur tension entre grille (ou drain) et source égale à leur tension de seuil.

La sortie Vcomp du circuit de référence de tension refc est prise au drain du transistor T405. La tension de référence Vcomp est donc égale à la tension de seuil du transistor T404.

Dans l'exemple, un transistor T406 de type N, dont la grille est reliée au signal de commande de tension H, le drain aux grilles des transistors T402 et T403, et la source aux grilles des transistors T404 et T405, permet d'amener un tel montage à miroirs de courant plus rapidement à l'équilibre.

La sortie S du comparateur est, comme on l'a vu en figure 1, rebouclée sur une porte NAND dont la sortie commande le circuit de claquage et le noeud B. L'autre entrée de la porte NAND est le signal de commande Cfus de claquage du fusible fus1. Seule une commande active de claquage associée à un état non claqué du fusible fus1 lu en sortie du comparateur permet le claquage du fusible fus1. La sortie de la porte NAND bloque alors les transistors Tf1 et Tf2.

Le circuit de claquage CLAQ amène alors la tension de claquage au noeud A1, via le transistor Tc1, dans l'exemple natif (tension de seuil nulle) : la grille et la source du transistor Tc1 sont alors portées à la tension Vpp.

Quand le fusible fus1 n'est pas claqué, il est équivalent à une capacité et la capacité de drain du transistor Tc1 s'ajoute à la capacité du fusible fus1. C'est pour cette raison, et toujours pour que les deux entrées e1 et e2 du comparateur soient parfaitement équilibrées, que le transistor Tc2 identique à Tc1 est nécessaire. C'est le seul but de ce transistor Tc2 que de rendre les deux branches entre chacun des fusibles et chaque entrée parfaitement symétrique. Cette symétrie sera d'ailleurs également respectée pour la topographie de l'ensemble du circuit de détection selon l'invention : l'ensemble des circuits connectés à un fusible est topologiquement symétrique à l'ensemble des circuits connectés à l'autre fusible.

## Revendications

1. Circuit de détection d'un premier fusible (fus1) à deux états possibles, du type à claquage vertical d'oxyde, caractérisé en ce qu'il comporte un second fusible (fus2) du même type, mais qui ne peut pas être claqué, le premier fusible (fus1) comportant en parallèle, entre la masse et un premier point d'entrée (e1) d'un comparateur différentiel (COMP), un premier circuit de référence de tension (ref1), et le second fusible (fus2) comportant en parallèle, entre la masse et un second point d'entrée (e2) d'un comparateur différentiel (COMP), un second circuit de référence de tension (ref2).

2. Circuit de détection selon la revendication 1, caractérisé en ce que le premier circuit de référence de tension (ref1) associé au premier fusible à deux états possibles (fus1) et le second circuit de référence de tension (ref2) associé au fusible qui ne peut pas être claqué (fus2) sont technologiquement identiques.

3. Circuit de détection selon la revendication 2, caractérisé en ce qu'un transistor (Tf1) est monté en série entre le premier fusible à deux états possibles (fus1) et le premier point d'entrée (e1) du comparateur différentiel (COMP), le transistor étant commandé sur sa grille par la combinaison NAND logique d'un signal de commande de claquage (Cfus) du premier fusible à deux états possibles (fus1) et de la sortie (S) du comparateur.

4. Circuit de détection selon la revendication 3, caractérisé en ce qu'un transistor (Tf2) est monté en série entre le second fusible (fus2) et le second point d'entrée (e2) du comparateur différentiel (COMP), le transistor étant commandé sur sa grille par la combinaison NAND logique d'un signal de commande de claquage (Cfus) du premier fusible à deux états possibles (fus1) et de la sortie (S) du comparateur.

5. Circuit de détection selon la revendication 4, la tension de claquage étant appliquée au premier fusible à deux états possibles (fus1) par un premier transistor de commande de tension (Tc1) en série avec ce premier fusible (fus1), caractérisé en ce que l'on place un second transistor (Tc2) de caractéristiques identiques au premier, en série avec le second fusible (fus2).

6. Circuit de détection selon les revendications 1, 2 ou 4, caractérisé en ce que l'ensemble des circuits connectés à un fusible est topologiquement symétrique à l'ensemble des circuits connectés à l'autre fusible.

7. Circuit de détection selon l'une des revendications précédentes, comportant un circuit de référence de tension (refc) associée au comparateur différentiel (COMP), caractérisé en ce qu'une référence de tension (Vcomp) produite par le circuit de référence de tension (refc) est indépendante de l'alimentation Vcc.

## Patentansprüche

1. Detektorschaltung mit einer ersten Sicherung (fus 1), die zwei Zustände annehmen kann und von der Art mit vertikalem Oxiddurchbruch ist, dadurch gekennzeichnet, daß sie eine zweite Sicherung (fus2) der gleichen Art enthält, bei der jedoch kein Durchbruch auftreten kann, daß der ersten Sicherung (fus1) zwischen der Masse und einer ersten Eingangsstelle (e1) eines Differenzkomparators (COMP) ein erster Bezugsspannungs-Schaltkreis (ref1) parallelgeschaltet ist, und daß der zweiten Sicherung (fus2) zwischen der Masse und einer zweiten Eingangsstelle (e2) eines Differenzkomparators (COMP) ein zweiter Referenzspannungs-Schaltkreis (ref2) parallelgeschaltet ist.

2. Detektorschaltung nach Anspruch 1, dadurch gekennzeichnet, daß der der ersten Sicherung (fus1) mit zwei möglichen Zuständen zugeordnete erste Bezugsspannungs-Schaltkreis (ref1 ) und der zweite Bezugsspannungs-Schaltkreis (ref2), der der Sicherung (fus2) zugeordnet ist, bei der kein Durchbruch auftreten kann, technologisch identisch sind.

3. Detektorschaltung nach Anspruch 2, dadurch gekennzeichnet, daß ein Transistor (Tf1) zwischen die erste Sicherung (fus1) mit zwei möglichen Zuständen und die erste Eingangsstelle (e1) des Differenzkomparators (COMP) in Reihe geschaltet ist, wobei der Transistor über sein Steuergitter durch die logische NAND-Verknüpfung zwischen einem Durchbruchsteuersignal (Cfus) der ersten Sicherung (fus1) mit zwei möglichen Zuständen und dem Ausgangssignal (S) des Komparators angesteuert ist.

4. Detektorschaltung nach Anspruch 3, dadurch gekennzeichnet, daß ein Transistor (Tf2) zwischen die zweite Sicherung (fus2) und die zweite Eingangsstelle (e2) des Differenzkomparators (COMP) in Reihe geschaltet ist, wobei der Transistor über sein Steuergitter durch die logische NAND-Verknüpfung zwischen einem Durchbruchsteuersignal (Cfus) der ersten Sicherung (fus 1) mit zwei möglichen Zuständen und dem Ausgangssignal (S) des Komparators angesteuert ist.

5. Detektorschaltung nach Anspruch 4, bei der die Durchbruchspannung der ersten Sicherung (fus1) mit zwei möglichen Zuständen über einen ersten Spannungssteuerungstransistor (Tc1) zugeführt ist, der mit der ersten Sicherung (fus1) in Reihe geschaltet ist, dadurch gekennzeichnet, daß ein zweiter Transistor (Tc2), der die gleichen Merkmale wie der erste besitzt, mit der zweiten Sicherung (fus2) in Reihe geschaltet wird.

6. Detektorschaltung nach den Ansprüchen 1, 2 oder 4, dadurch gekennzeichnet, daß die Einheit der mit einer Sicherung verbundenen Schaltkreise topologisch zu der Einheit der mit der anderen Sicherung verbundenen Schaltkreise symmetrisch ist.

7. Detektorschaltung nach einem der vorhergehenden Ansprüche, die einen dem Differenzkomparator (COMP) zugeordneten Bezugsspannungs-Schaltkreis (refc) enthält, dadurch gekennzeichnet, daß eine von dem Bezugsspannungs-Schaltkreis (refc) erzeugte Bezugsspannung (Vcomp) unabhängig von der Versorgungsspannung Vcc ist.

## Claims

1. A detection circuit for a first fuse (fus1) with two possible states, of the type having vertical oxide blowing, characterised in that it includes a second fuse (fus2) of the same type but which cannot be blown, the first fuse (fus1) including in parallel, between earth and a first input point (e1) of a differential comparator (COMP), a first voltage reference circuit (ref1), and the second fuse (fus2) including in parallel, between earth and a second input point (e2) of a differential comparator (COMP), a second voltage reference circuit (ref2).

2. A detection circuit according to Claim 1, characterised in that the first voltage reference circuit (ref1) associated with the first fuse having two possible states (fus1), and the second voltage reference circuit (ref2) associated with the fuse that cannot be blown (fus2), are technologically identical.

3. A detection circuit according to Claim 2, characterised in that a transistor (Tf1) is connected in series between the first fuse having two possible states (fus1) and the first input point (e1) of the differential comparator (COMP), the transistor being controlled at its gate by the logic NAND combination of a control signal (Cfus) for the blowing of the first fuse having two possible states (fus1) and the output (S) of the comparator.

4. A detection circuit according to Claim 3, characterised in that a transistor (Tf2) is connected in series between the second fuse (fus2) and the second input point (e2) of the differential comparator (COMP), the transistor being controlled at its gate by the logic NAND combination of a control signal (Cfus) for the blowing of the first fuse having two possible states (fus1) and the output (S) of the comparator.

5. A detection circuit according to Claim 4, the blowing voltage being applied to the first fuse having two possible states (fus1) by a first voltage control transistor (Tc1) in series with the said first fuse (fus1), characterised in that a second transistor (Tc2) having characteristics identical with the first, is connected in series with the second fuse (fus2).

6. A detection circuit according to any one of Claims 1, 2 or 4, characterised in that the set of circuits connected to one fuse is topologically symmetrical to the set of circuits connected to the other fuse.

7. A detection circuit according to one of the preceding Claims, comprising a voltage reference circuit (refc) associated with the differential comparator (COMP), characterised in that a reference voltage (Vcomp) produced by the voltage reference circuit (refc) is independent of the supply (Vcc).
